Europäisches Patentamt

European Patent Office

Office européen des brevets

(11) Veröffentlichungsnummer: **0 004 301**
**B1**

(12) **EUROPÄISCHE PATENTSCHRIFT**

(45) Veröffentlichungstag der Patentschrift: **13.01.82**

(51) Int. Cl.³: **H 03 J 7/18**

(21) Anmeldenummer: **79100618.2**

(22) Anmeldetag: **02.03.79**

(54) Digitale Schaltung zur Erzeugung eines Stopsignals für die Suchlaufeinrichtung in einem Hochfrequenzempfänger.

(30) Priorität: **20.03.78 DE 2812113**

(43) Veröffentlichungstag der Anmeldung:
**03.10.79 Patentblatt 79/20**

(45) Bekanntmachung des Hinweises auf die Patenterteilung:
**13.01.82 Patentblatt 82/2**

(84) Benannte Vertragsstaaten:
**BE CH DE FR GB IT LU NL SE**

(56) Entgegenhaltungen:
**DE - B - 2 547 492**

**IEEE TRANSACTIONS ON CONSUMER ELECTRONICS, Vol. CE 24, Nr. 1, Februar 1978, New York, SASAKI et al.: "One-chip controlled voltage synthesizer TV tuning system", Seiten 57—66**

(73) Patentinhaber: **Licentia Patent-Verwaltungs-GmbH Theodor-Stern-Kai 1 D-6000 Frankfurt/Main 70 (DE)**

(72) Erfinder: **Klank, Otto, Ing.-grad. Marienburgstrasse 12 D-3161 Arpke (DE)**
Erfinder: **Rottmann, Dieter, Dipl.-Ing. Grenzstrasse 2a D-3000 Hannover 61 (DE)**

(74) Vertreter: **Einsel, Robert, Dipl.-Ing. Licentia Patent-Verwaltungs-GmbH Theodor-Stern-Kai 1 D-6000 Frankfurt/Main 70 (DE)**

(56) Entgegenhaltungen:
**IEEE TRANSACTIONS ON CONSUMER ELECTRONICS, Vol. CE 24, Nr. 4, November 1978, New York, MATSU-URA et al.: "Low cost digital tuning system with full-function automatic search preset", Seiten 545—551**

**RADIOMENTOR ELECTRONIC, Vol. 27, Nr. 8, August 1971, Berlin, DE, "Stereosender suchen sich selbst", Seite 58**

## Digitale Schaltung zur Erzeugung eines Stopsignals für die Suchlaufeinrichtung in einem Hochfrequenzempfänger

Es sind Rundfunkempfänger mit einer Suchlaufeinrichtung bekannt (z.B. Funkschau 1976, Heft 9, S. 365 und 366) die wahlweise in beiden Abstimmrichtungen betrieben werden kann. Bei derartigen Suchlaufschaltungen wird der Suchlauf durch Betätigen eines Bedienungsknopfes eingeschaltet und durch ein beim Empfang eines Senders entstehendes Stopsignal automatisch beendet oder unterbrochen. Das Stopsignal wird von der S-förmigen Ausgangsspannung des Demodulators des Empfängers abgeleitet. Da bei dem Suchlauf in der einen Richtung zuerst der positive Höcker und bei einem Suchlauf in der anderen Richtung zuerst der negative Höcker der S-förmigen Ausgangsspannung des Demodulators auftritt, muß das Ausgangssignal richtungsabhängig ausgewertet werden. Das Stopsignal soll im Null-Durchgang oder in der Nähe des Null-Durchganges der Ausgangsspannung des Demodulators entstehen.

Es ist durch die DE—AS 25 47 492 bereits eine Abstimmschaltung für einen automatischen Suchlauf bekannt, die im wesentlichen mit digital arbeitenden Mitteln aufgebaut ist. Bei dieser bekannten Schaltung wird in einem Suchlaufgenerator eine rampenfömige Abstimmspannung erzeugt, die in einer Richtung von kleinen zu größeren Werten hin veränderbar ist. Beim Empfang eines Senders wird von dem zuerst auftretenden, positiven Höcker der S-förmigen Demodulatorspannung des Empfängerdemodulators ein den Suchlauf unterbrechender Stop-Impuls abgeleitet. Der Stop-Impuls wird von der rückwärtigen Flanke des zu einem Rechteckimpuls geformten Höckers der Demodulatorspannung abgeleitet. Diese bekannte Schaltung ist nicht ohne weiteres für einen Suchlauf in entgegengesetzter Richtung geeignet, da bei der entgegengesetzten Richtung der positive Höcker erst nach dem Nulldurchgang der Demodulatorspannung auftritt.

Der Erfindung liegt die Aufgabe zugrunde, eine digitale Steuerschaltung für einen Suchlaufempfänger zu schaffen, die für die Steuerung eines Suchlauf in beiden Suchlaufrichtungen geeignet ist.

Diese Aufgabe wird durch die im Patentanspruch 1 angegebene Erfindung gelöst. In den Unteransprüchen sind vorteilhafte Ausführungsbeispiele und Weiterbildungen der Erfindung angegeben.

Die Erfindung wird im folgenden anhand von in der Zeichnung dargestellten Ausführungsbeispielen erläutert. Es zeigen

Fig. 1 eine Schaltung zur richtungsabhängigen Auswertung des Demodulatorausgangssignals,

Fig. 2 Signal-Diagramme zur Schaltung gemäß Fig. 1,

Fig. 3 eine detaillierte Schaltung zur Steuerung des Suchlaufes in einem Rundfunkempfänger,

Fig. 4 ein weiteres Ausführungsbeispiel einer Steuerschaltung und

Fig. 5 eine Impulsformer-Schaltung für die Schaltung gemäß Fig. 4.

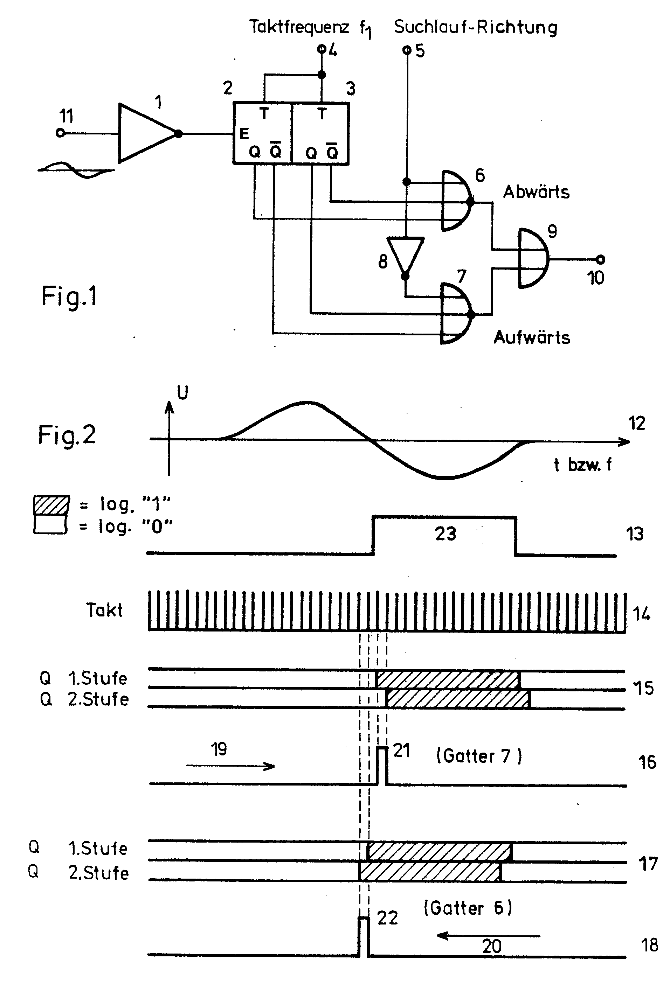

In Fig. 1 ist eine Schaltung dargestellt, mittels der von dem S-förmigen Ausgangssignal des Demodulators eines Hochfrequenzempfängers ein Stopsignal abgeleitet wird, mit dem die Beendigung des Suchlaufes gesteuert wird. Fig. 2 zeigt Diagramme zur Erläuterung der Schaltung gemäß Fig. 1. Das S-förmige Ausgangssignal des nicht dargestellten Demodulators des Empfängers leigt an der Eingangsklemme 11 eines invertierenden Verstärkers 1. Der Verstärker 1 formt aus dem S-förmigen Ausgangssignal (12 in Fig. 2) ein in Zeile 13 dargestelltes rechteckförmiges Signal 23 mit den logischen Pegeln "0" und "1". Der Ausgang des Verstärkers 1 ist mit dem Eingang eines aus zwei Stufen 2 und 3 bestehenden Schieberegisters verbunden. An die Takteingänge T der Stufen 2 und 3 des Schieberegisters ist eine feste Taktfrequenz $f_1$ gelegt, die über eine Eingangsklemme 4 zugeführt wird. Die sehr kurzen Taktimpulse sind in Fig. 2 in Zeile 14 wiedergegeben. Mit den Ausgängen Q und $\overline{Q}$ ist eine Verknüpfungsschaltung aus den NOR-Gattern 6 und 7 und dem OR-Gatter 9 verbunden. Die NOR-Gatter 6 und 7 werden als UND-Verknüpfungsglieder verwendet. Wenn an allen Eingängen des NOR-Gatters 6 bzw. 7 das logische Signal "0" liegt, so ist die UND-Bedingung erfüllt und am Ausgang des Gatters erscheint das logische Signal "1". Der untere Eingang des Gatters 6 ist mit dem Ausgang Q der Stufe 2 und der mittlere Eingang mit dem Ausgang $\overline{Q}$ der Stufe 3 des Schieberegisters verbunden, so daß diese Eingänge des Gatters 6 beide das logische Signal "0" aufweisen, wenn der Inhalt des Schieberegisters "01" ist. Die unteren beiden Eingänge des Gatters 7 sind mit den jeweils entgegengesetzten Ausgängen der Stufen 2 und 3 des Schieberegisters verbunden, so daß diese beiden Eingänge logisch "0" aufweisen, wenn das Schieberegister auf "10" steht. Durch ein logisches Signal an der Eingangsklemme 5 der Schaltung wird am oberen Eingang der Gatter 6 und 7 vorgegeben, bei welchem der Gatter 6 und 7 die UND-Bedingung erfüllt werden kann. Das Signal an der Eingangsklemme 5 erscheint am Gatter 7 wegen eines zwischengeschalteten Invertierers 8 invertiert. Bei einem Suchlauf in Aufwärtsrichtung liegt an der Eingangsklemme 5 logisch "1", womit das Gatter 6 gesperrt ist und für das Gatter 7 die Erfüllung der UND-Bedingung ermöglicht ist. Das Gatter 7 ist also wirksam geschaltet. Umgekehrt liegen die Verhältnisse bei einem Suchlauf in Abwärtsrichtung, bei dem infolge eines logischen Signales "0" an der Eingangsklemme 5 das Gatter 7 gesperrt und das Gatter 6 wirksam geschaltet ist. Die Signale an den Ausgängen der Gatter 6 und 7 sind in einem OR-Gatter 9 zusammengefaßt und werden zu einer Ausgangsklemme 10 geleitet.

Die Schaltung arbeitet folgendermaßen: Das Rechtecksignal 23 in Zeile 13 der Fig. 2 wird durch die Taktimpulse in Zeile 14 entsprechend Zeile 15 in die Stufen des Schieberegisters eingelesen. Eine Änderung des Signales am Eingang E des Schieberegisters erscheint in der zweiten Stufe 3 des Schieberegisters um einen Takt verzögert. Der zwischenzeitlich eingenommene Zustand "01" bzw. "10" des Schieberegisters wird für Gewinnung des Stopsignales ausgenutzt. Beim Suchlauf in Aufwärtsrichtung ist vom ersten Taktimpuls, der in die Zeit des Taktimpulses 23 fällt, bis zum zweiten Taktimpuls die UND-Bedingung am Gatter 7 erfüllt (Zeile 15 in Fig. 2), so daß am Ausgang 10 des Gatters 7 der in Zeile 16 dargestellte Impuls 21 entsteht. Die zugehörige Suchlaufrichtung ist in Zeile 16 der Fig. 2 durch eine Pfeil 19 angedeutet.

Beim Suchlauf in Abwärtsrichtung (Pfeil 20 in Fig. 2, Zeile 18) muß nicht die Vorderflanke des Rechteckimpulses 23 für die Erzeugung des Stopsignales herangezogen werden, sondern die rückwärtige Flanke. Aus diesem Grund wird jetzt vom Gatter 6 der umgekehrte Zwischenzustand des Schlieberegisters für die Bildung des Stopimpulses 22 in Zeile 18 ausgewertet, wie aus Zeile 17 zu erkennen ist.

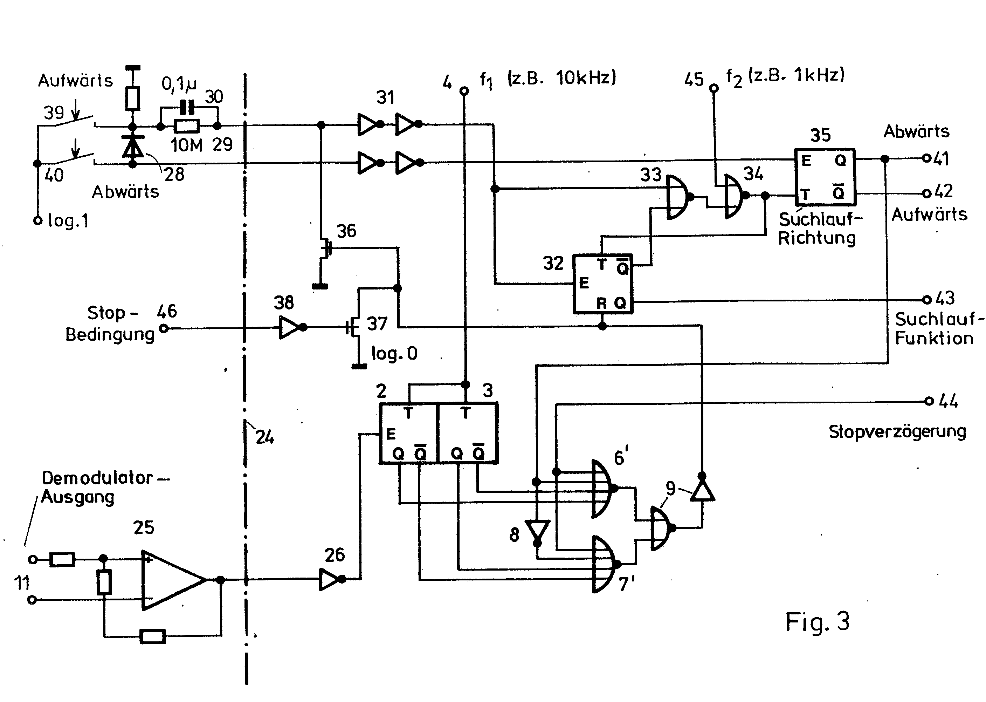

In Fig. 3 ist eine Steuerschaltung zur Steuerung des Suchlaufes dargestellt. Die rechts von der strichpunktierten Linie 24 dargestellten Schaltungsteile sind für die Realisierung in einem MOS—IC gedacht. Die verwendeten Gatter sind als invertierende Elemente ausgeführt, da diese in MOS-Tecknik leichter zu realisieren sind. Die der Schaltung in Fig. 1 entsprechenden Schaltungsteile sind mit den gleichen Bezugszeichen versehen. Das Ausgangssignal des dem Verstärker 1 in Fig. 1 entsprechenden Verstärkers 25 wird im IC in einem zusätzlichen Inverter 26 invertiert.

Die Steuerschaltung in Fig. 3 enthält ein Flip-Flop 32, das während des Suchlaufes gesetzt ist (Ausgang Q auf logisch "1"). Links oben in Fig. 3 ist ein Schalter 39 zur Einschaltung des Suchlaufes in Aufwärtsrichtung und ein Schalter 40 zur Einschaltung des Suchlaufes in Abwärtsrichtung dargestellt. Das erwähnte Flip-Flop 32 erhält an seinem Eingang E beim Betätigen eines der Schalter 39 und 40 ein logisches Signal "1" und wird dadurch gesetzt. Vom Schalter 39 wird das logische Signal "1" über das RC-Glied 29, 30 und zwei entkoppelnde und verstärkende Inverter 31 zum Eingang E des Flip-Flips 32 übertragen. Vom Schalter 40 nimmt das Signal den gleichen Weg, jedoch zusätzlich über eine Diode 28. Der am Eingang E des Flip-Flops 32 anliegende logische Zustand wird durch einen Taktimpuls am Takteingang T in das Flip-Flop 32 übernommen. Das Flip-Flop 32 kann an einem Rücksetzeingang R durch das schon bei Fig. 1 erwähnte Stopsignal beim Erreichen eines Senders zurückgesetzt werden. Für die Steuerung des Suchlaufes steht an einer mit dem Ausgang Q des Flip-Flops 32 verbundenen Ausgangsklemme 43 ein Steuersignal zur Verfügung.

Es ist ein weiteres Flip-Flop 35 zur Speicherung der Suchlaufrichtung vorgesehen. Beim Betätigen des Schalters 40 erscheint am Eingang E des Flip-Flops 35 das Signal logisch "1" und beim Betätigen des Schalters 39 das Signal logisch "0". Dem Takteingang T des Flip-Flops 35 werden Taktimpulse von einer Eingangsklemme 45 über ein NOR-Gatter 34 zugeführt. Sie haben die Frequenz $f_2$, die z.B. 1 kHz beträgt. Das NOR-Gatter 34 ist in der Ausgangsstellung der Schaltung geöffnet, da der untere Eingang des Gatters 34 sich im logischen Zustand "0" befindet. Der Zustand des unteren Einganges des Gatters 34 ist von dem Ausgangssignal eines NOR-Gatters 33 bestimmt, dessen Eingänge mit dem Eingang E und dem Ausgang $\bar{Q}$ des Flip-Flops 32 verbunden sind. Da im Ausgangszustand der Schaltung das Signal am Ausgang $\bar{Q}$ des Flip-Flops 32 logisch "1" ist, steht der Ausgang des Gatters 33 auf logisch "0". Dieser Zustand bleibt enthalten, wenn der Suchlauf mit den Tasten 39 oder 40 gestartet wird. Der Eingang E des Flip-Flops 32 wird nämlich "1", bevor der Ausgang $\bar{Q}$ auf "0" wechselt. Das Gatter 34 wird für die Taktimpulse mit der Frequenz $f_2$ gesperrt, wenn vor Ende des Suchlaufvorganges die Taste 39 bzw. 40 geöffnet wird. Die Suchlauffunktion und die Suchlaufrichtung sind damit fest gespeichert und können nur durch ein Stopsignal am Rücksetzeingang R des Flip-Flops 32 gelöscht werden.

Für die Gewinnung der Abstimmspannung kann die integrierte Schaltung CA 3080 des Herstellers RCA verwendet werden, wobei die Ausgangsklemmen 41 und 42 der Schaltung in Fig. 3 mit entsprechenden Steuereingängen der integrierten Schaltung zu verbinden ist. Die Klemme 43 kann über einen die Suchlaufgeschwindigkeit vorgebenden Widerstand mit dem mit "bias" bezeichneten Eingang der integrierten Schaltung verbunden werden. Im folgenden sei noch auf einige Besonderheiten der Schaltung in Fig. 3 hingewiesen. Die mit 6' und 7' bezeichneten und den Gattern 6 und 7 in Fig. 1 entsprechenden Gatter weisen jeweils einen zusätzlichen Eingang auf. Diese Eingänge sind zusammengeführt und mit einer Eingangsklemme 44 verbunden. Durch ein Signal logisch "1" an der Eingangsklemme 44, das beim Start des Suchlaufes für eine kurze Zeit angelegt wird, werden die Gatter 6' und 7' kurzzeitig gesperrt, wodurch vermieden wird, daß der gleiche Sender, der vorher eingestellt war, wieder eingefangen wird.

Über eine Eingangsklemme 46 kann eine Stopbedingung eingeführt werden. Durch ein logisches Signal an der Eingangsklemme 46 kann über einen Inverter 38 ein FET-Transistor 37 leitend gesteuert werden, um ein Stopsignal zu unterdrücken. Durch die Stopbedingung kann eine Auswahl zwischen verschiedenen empfangbaren Sendern getroffen werden. Wenn beispielsweise nur Stereosender empfangen werden sollen, so muß von einer zusätzlichen Prüfschaltung das empfangene Signal geprüft und bei Nicht-Stereosendern der Transistor 37 leitend gesteuert werden. Durch einen FET-Transistor 36 ist ein Betrieb möglich, bei dem bei jedem durch den Suchlauf eingestellten Sender eine vorgegebene Zeit angehalten wird und nach dieser Zeit der Suchlauf erneut automatisch gestartet wird, sofern der betätigte Suchlaufschalter noch geschlossen ist. Der linke Anschluß des Kondensators 30 liegt, wenn einer der Schalter 39 und 40 betätigt ist, auf dem dem logischen Signal "1" entsprechenden Pegel. Am Kondensator 30 liegt zunächst, da dieser mittels eines hochohmigen Widerstandes 29 überbrückt ist, keine Spannung. Durch das Stop signal wird der Transistor 36 leitend, wodurch der Kondensator 30 schlagartig aufgeladen wird. Das Flip-Flop 32 wird durch den Stopimpuls zurückgesetzt und zunächst nicht wieder gesetzt, weil infolge der Spannung am Kondensator 30 am Eingang E des Flip-Flops nicht mehr das logische Signal "1" erscheint. Nach einer durch die Zeitkonstante des RC-Gliedes 29, 30 gegebenen Zeit erscheint am Eingang E des Flip-Flops 32 wieder das von dem betätigten Schalter eingeschaltete logische Signal "1" und der Suchlauf wird erneut mit der gleichen Richtung gestartet.

Da das die Unterbrechungsdauer des Suchlaufes vorgebende Zeitglied 29, 30 außerhalb der integrierten Schaltung liegt, kann die Unterbrechungszeit durch eine entsprechende Dimensionierung des Zeitgliedes 29, 30 beliebig gewählt werden.

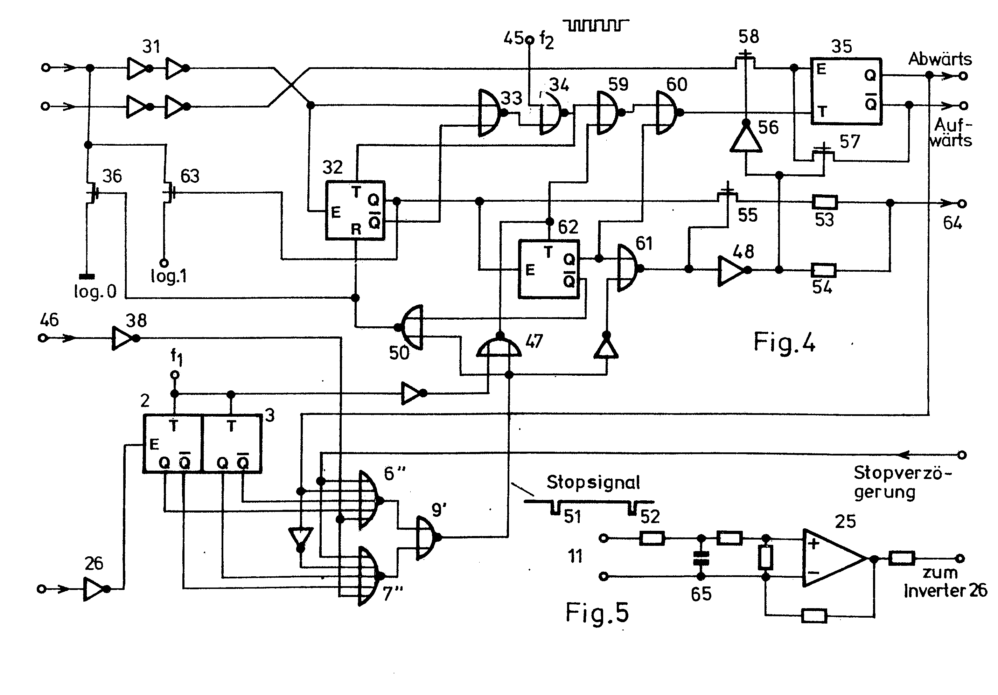

In Fig. 4 ist eine Schaltung dargestellt, bei der ein Sender durch Überlaufen der richtigen Abstimmlage und einen anschließenden kurzen Rücklauf schneller eingestellt werden kann als bei der Schaltung nach Fig. 3. Dazu ist zusätzlich zu den schon in Fig. 3 vorhandenen Flip-Flops 32 und 35 ein weiteres ebenfalls taktgesteuertes Flip-Flop 62 vorgesehen.

Zunächst werden bei der Einschaltung des Suchlaufes die Flip-Flop 32 und 35 gesetzt. Durch eine Rückkopplung vom Ausgang Q des Flip-Flops 32 über einen Transistor 63 und die Inverter 31 zum Eingang E wird der Zustand logisch "1" am Eingang E des Flip-Flops 32 festgehalten. Der dann am Ausgang Q des Flip-Flops 32 liegende logische Zustand "1" erscheint am Eingang E des Flip-Flops 62. Das invertierte Stopsignal am Gatter 9' (in Fig. 4 unten) wird über ein NOR-Gatter 47 zum Takteingang T des Flip-Flops 62 übertragen. Vor dem Erreichen eines Senders befindet sich das Flip-Flop 62 im Ausgangszustand, in dem am Ausgang Q der logische Zustand "0" herrscht.

In Abhängigkeit von der Stellung des Flip-Flops 62 wird die Geschwindigkeit des Suchlaufes gesteuert. Es sind zwei Widerstände 53 und 54 vorgesehen, die den Ladestrom eines nicht dargestellten Kondensators, in dem die Abstimmspannung gebildet wird, bestimmen. Vor dem Erreichen eines Senders liegt am linken Anschluß des Widerstandes 53 der logische Zustand "1", so daß der Ladestrom vom Widerstand 53 bestimmt wird. Am linken Anschluß des Widerstandes 54 liegt noch der logische Zustand "0", entsprechend dem von einem Gatter 61 und einem Inverter 68 übertragenen Ausgangssignal am Ausgang Q des Flip-Flops 62. Durch das in diesem Zustand vor dem Inverter 48 auftretende Signal "1" wird ein vor dem Widerstand 53 liegender Transistor 55 leitend geschaltet.

Vom Ausgang Q̄ des die Suchlaufrichtung speichernden Flip-Flops 35 zum Eingang E dieses Flip-Flops 35 ist eine Verbindung über einen Transistor 57 geschaffen. Die im Flip-Flop 35 gespeicherte Suchlaufrichtung kann dadurch umgekehrt werden, daß der Transistor 57 leitend gemacht und auf dem Takteingang T ein Taktimpuls gegeben wird. Der Eingang E des Flip-Flops 35 kann mittels eines Transistors 58 für ein von den in Fig. 4 nicht dargestellten Bedienungsschaltern kommendes Signal gesperrt werden. Die Transistoren 57 und 58 sind zueinander invertiert (Inverter 56) durch das Signal am Ausgang des Inverters 48 angesteuert. Vor dem Erreichen eines Senders ist der Transistor 58 leitend und der Transistor 57 gesperrt.

Das Stopsignal am Ausgang des Gatters 9' wird est kurzzeitig nach dem Erreichen eines Senders abgegeben, nachdem der Sender also schon überlaufen ist. Diese Verzögerung wird, wie in Fig. 5 dargestellt, durch einen Kondensator 65 vor dem Verstärker 25 erreicht. Durch das in Fig. 4 mit 51 bezeichnete, erste Stopsignal wird das Flip-Flop 62 gesetzt. Dadurch wird am linken Anschluß des Widerstandes 54 der logische Zustand "1" erzeugt. Mit diesem Wechsel werden zugleich die Transistoren 55 und 58 gesperrt und der Transistor 57 leitend gesteuert. In diesem Zustand wird die Suchlaufgeschwindigkeit allein von dem Wert des Widerstandes 54 bestimmt. Der Wert des Widerstandes 54 ist größer als der Wert des Widerstandes 53 bemessen, so daß die Suchlaufgeschwindigkeit auf einen kleineren Wert umgeschaltet ist.

Durch einen Taktimpuls gleichzeitig mit dem Setzen des Flip-Flops 62 am Takteingang T des Flip-Flops 35 wird der Zustand im Flip-Flop 35 umgekehrt. Das bedeutet, daß nach dem ersten Stopsignal 51 der Suchlauf mit umgekehrter Richtung und verlangsamter Geschwindigkeit fortgesetzt wird. Das Flip-Flop 62 sperrt über das Gatter 60 die Takte für das Flip-Flop 35, so daß die neue Richtungsinformation erhalten bleibt. Kurz danach wird der Sender erneut erreicht, wodurch ein zweites Stopsignal 52 am Ausgang des Gatters 9' entsteht. Dieses zweite Stopsignal 52 gelangt über ein Gatter 50 zum Rücksetzeingang R des Flip-Flops 32. Das Gatter 50 war beim ersten Stopsignal 51 noch gesperrt, da der obere Eingang sich noch im logischen Zustand "1" befand. Durch das zweite Stopsignal 52 wird das Flip-Flop 32 zurückgesetzt und unmittelbar darauf ebenfalls das Flip-Flop 62. Dadurch erscheint an den linken Anschlüssen der Widerstände 53 und 54 jeweils der logische Zustand "0". Die Suchlaufgeschwindigkeit ist damit auf den Wert Null reduziert, der Suchlauf also abgeschaltet.

Die schon bei Fig. 3 erwähnte Stopbedingung ist in Fig. 4 in besonders einfacher Weise auf einen zusätzlichen Eingang der Gatter 6'' und 7'' geführt.

Die Gatter 33', 34', 59 und 60 dienen der gesteuerten Zufuhr von Taktimpulsen von der Eingangsklemme 45 zu den Takteingängen T der Flip-Flops 35 und 32.

**Patentansprüche**

1. Hochfrequenzempfänger mit einer Suchlaufeinrichtung, die durch ein Startsignal gestartet und durch ein Stopsignal (21, 22) gestoppt wird, wobei das Stopsignal (21, 22) von einem zu einem Rechtecksignal (23) verstärkten Ausgangssignal (12) eines Demodulators abgeleitet ist, dadurch gekennzeichnet, daß ein mindestens zweistufiges Schieberegister (2, 3) vorgesehen ist, das während des Suchlaufes fortwährend getaktet ist, daß das Rechtecksignal (23) dem Eingang (E) des Schieberegisters (2, 3) zugeführt ist, daß eine mit den Ausgängen (Q, $\overline{Q}$) der Stufen (2, 3) des Schieberegisters verbundene Verknüpfungsschaltung (6, 7, 9) vorgesehen ist, und daß die Verknüpfungsschaltung (6, 7, 9) mit der Suchlaufrichtung derart umschaltbar ist, daß bei beiden Suchlaufrichtungen am Ausgang der Verknüpfungsschaltung (6, 7, 9) jeweils an der Flanke des Rechtecksignals (23), die in der gesuchten Abstimmlage oder in der Nähe der Abstimmlage liegt, das Stopsignal (21, 22) entsteht.

2. Empfänger nach Anspruch 1, dadurch gekennzeichnet, daß das Schieberegister zwei Stufen (2, 3) umfaßt und daß das Stopsignal (21, bzw. 22) bei der einen Suchlaufrichtung (19) durch den logischen Zustand "10" der Schieberegisterstufen (2, 3) und bei der anderen Suchlaufrichtung (20) durch den logischen Zustand "01" erzeugt wird.

3. Empfänger nach Anspruch 2, dadurch gekennzeichnet, daß die Verknüpfungsschaltung zwei UND-Verknüpfungsglieder (6, 7) enthält, daß ein Eingang des einen UND-Verknüpfungsgliedes (6) mit dem nichtinvertierten Ausgang (Q) der ersten Stufe (2) des Schieberegisters und ein anderer Eingang des einen UND-Verknüpfungsgliedes (6) mit dem invertierten Ausgang ($\overline{Q}$) der zweiten Stufe (3) des Schieberegisters verbunden ist, daß ein Eingang des anderen UND-Verknüpfungsgliedes (7) mit dem invertierten Ausgang ($\overline{Q}$) der ersten Stufe (2) des Schieberegisters und ein anderer Eingang des anderen UND-Verknüpfungsgliedes (7) mit dem nichtinvertierten Ausgang (Q) der zweiten Stufe (3) des Schieberegisters verbunden ist, daß ein die Suchlaufrichtung angebendes Steuersignal (Klemme 5) an einen weiteren Eingang des einen UND-Verknüpfungsgliedes (6) und invertiert mit einem weiteren Eingang des anderen UND-Verknüpfungsgliedes (7) gelegt ist, daß die Ausgänge der beiden UND-Verknüpfungsglieder (6, 7) mit den Eingängen eines ODER-Verknüpfungsgliedes (9) verbunden sind und daß am Ausgang des ODER-Verknüpfungsgliedes (9) das Stopsignal (21, 22) entnommen ist.

4. Empfänger nach Anspruch 3, dadurch gekennzeichnet, daß die UND-Verknüpfungsglieder durch je ein NOR-Gatter (6, 7) gebildet sind.

5. Empfänger nach Anspruch 3, dadurch gekennzeichnet, daß die UND-Verknüpfungsglieder (6, 7) über einen weiteren Eingang oder mehrere weitere Eingänge zur Unterdrückung des Stopsignals (21, 22) sperrbar sind.

6. Empfänger nach Anspruch 5, dadurch gekennzeichnet, daß die UND-Verknüpfungsglieder (6', 7') durch ein für eine vorgegebene Zeit nach einem Suchlauf-Start- auftretendes Signal (Stop-Verzögerung, Klemme 44) sperrbar sind.

7. Empfänger nach Anspruch 5, dadurch gekennzeichnet, daß die UND-Verknüpfungsglieder (6'', 7'') durch ein bei bestimmten Sendern, beispielsweise bei Monosendern, erzeugtes Signal (Stop-Bedingung, Klemme 46) sperrbar sind.

8. Empfänger nach Anspruch 1, dadurch gekennzeichnet, daß ein erstes Flip-Flop (32) vorgesehen ist, das während des Suchlaufes gesetzt ist, und daß das erste, Flip-Flop (32) durch das Stopsignal zurücksetzbar ist.

9. Empfänger nach Anspruch 8, dadurch gekennzeichnet, daß ein zweites Flip-Flop (35) vorgesehen ist, das je nach gewählter Suchlaufrichtung in die eine oder andere Lage setzbar ist.

10. Empfänger nach Anspruch 9, dadurch gekennzeichnet, daß ein drittes Flip-Flop (62) vorgesehen ist, das durch ein erstes Stopsignal (51) setzbar ist, daß das dritte Flip-Flop (62) mit dem ersten (32) und dem zweiten (35) Flip-Flop durch logische Verknüpfungsglieder (50, 61, 48, 57, 58) so zusammengeschaltet, ist daß die Stellung des zweiten Flip-Flops (35) mit dem Setzen des dritten Flip-Flops (62) umgekehrt wird und daß das erste Flip-Flop (32) erst durch ein zweites Stopsignal (52), nachdem das dritte Flip-Flop (62) durch das erste Stopsignal (51) gesetzt worden ist, zurücksetzbar ist.

11. Empfänger nach Anspruch 8, dadurch gekennzeichnet, daß das erste Flip-Flop (32) durch Bedienungstasten (39, 40) setzbar ist, daß im Signalweg von den Bedienungstasten (39, 40) zu dem ersten Flip-Flop (32) ein Kondensator (30) liegt, daß ein von dem Stopsignal betätigter elektronischer Schalter (Transistor 36) vorgesehen ist, der mit dem Kondensator (30) so zusammengeschaltet ist, daß dieser infolge des Stopsignales einen Lade-Spannungswert erhält, durch den das von der betätigten Bedienungstaste (39 oder 40) erzeugte Signal aufgehoben wird, und daß der Kondensator durch einen Widerstand (29) mit einer Zeitkonstanten wieder um- bzw. entladen wird.

12. Empfänger nach Anspruch 11, dadurch gekennzeichnet, daß der Kondensator (30) in Serie in der Signalleitung zum Eingang (E) des ersten Flip-Flops (32) liegt, daß der Widerstand (29) parallel geschaltet ist, daß der den Bedienungstasten (39, 40) zugewandte Anschluß des Kondensators (30) beim Betätigen einer Bedienungstaste (39 oder 40) mit dem einen Pol einer Versorgungsspannung (logisch "1") und der andere Anschluß durch den elektronischen Schalter (36) mit dem anderen Pol der Versorgungsspannung (Masse, logisch "0") verbindbar ist.

13. Empfänger nach Anspruch 11 oder 12, dadurch gekennzeichnet, daß der elektronische Schalter als Schalttransistor (36) ausgeführt ist.

**Claims**

1. A high frequency receiver with a search device which is started by means of a starting signal and is stopped by means of a stop signal (21, 22), the stop signal (21, 22) being derived from an output signal (12) of a demodulator, which is amplified to form a square wave signal (23), characterised in that there is provided a shift register (2, 3) having at least two stages and which is clocked continuously during the search operation; that the square wave signal (23) is supplied to the input (E) of the shift register (2, 3); that there is provided a coupling circuit (6, 7, 9) which is connected to the output (Q, Q̄) of the stages (2, 3) of the shift register; and that the coupling circuit (6, 7, 9) can be switched with the direction of search, such that in both search directions the stop signal (21, 22) arises at the output of the coupling circuit (6, 7, 9) in each case at the flank of the square wave signal (23) which lies in the searched tuning position or near thereto.

2. A receiver according to claim 1 characterised in that the shift register includes two stages (2, 3); and that the stop signal (21 or 22 respectively) is produced in one search direction (19) by the logic condition "10" of the shift register stages (2, 3) and in the other search direction (20) by the logic condition "01".

3. A receiver according to claim 2, characterised in that the coupling circuit comprises two AND coupling elements (6, 7) that one input of one AND coupling element (6) is connected to the non-inverted output (Q) of the first stage (2) of the shift register and another input of said one AND coupling element (16) is connected to the inverted output (Q̄) of the second stage (3) of the shift register; that one input of the other AND coupling element (7) is connected to the inverted output (Q̄) of the first stage (2) of the shift register and another input of the other AND coupling element (7) is connected to the non-inverted output (Q) of the second stage (3) of the shift register; that a control signal (terminal 5) determining the search direction is applied to a further input of said one AND coupling element (6) and is applied to a further input of the other AND coupling element (7) in inverted form; that the outputs of the two AND coupling elements (6, 7) are connected to the inputs of an OR coupling element (9); and that the stop signal (21, 22) is derived at the output of the OR coupling element (9).

4. A receiver according to claim 3 characterised in that the AND coupling elements are formed by a NOR gate (6, 7) in each case.

5. A receiver according to claim 3 characterised in that the AND coupling elements (6, 7) can be blocked via a further input or several further inputs for suppressing the stop signal (21, 22).

6. A receiver according to claim 5 characterised in that the AND coupling elements (6', 7') can be blocked by means of a signal (stop delay, terminal 44) which appears for a predetermined time after the start of a search.

7. A receiver according to claim 5 characterised in that the AND coupling elements (6'', 7'') can be blocked by means of a signal (stop condition, terminal 46) produced in certain transmitters for example in mono-transmitters.

8. A receiver according to claim 1 characterised in that a first trigger circuit (32) is provided which is set during the search; and that the first trigger circuit (32) can be reset by the stop signal.

9. A receiver according to claim 8 characterised in that a second trigger circuit (35) is provided which can be set into one or another position depending on the search direction selected.

10. A receiver according to claim 9 characterised in that a third trigger circuit (62) is provided which can be set by a first stop signal (51); that the third trigger circuit (62) is connected to the first (32) and the second (35) trigger circuits by means of logic coupling elements (50, 61, 48, 57, 58) so that the state of the second trigger circuit (35) is reversed by setting the third trigger circuit (62); and that the first trigger circuit (32) can only be reset by a second stop signal (52) after the third trigger circuit (62) has been set by the first stop signal (51).

11. A receiver according to claim 8 characterised in that the first trigger stage (32) can be set by operating keys (39, 40); that a capacitor (30) lies in the signal path from the operating keys (39, 40) to the first trigger stage (32); that an electronic switch (transistor 36) actuated by the stop signal is provided and is connected to the capacitor (30) so that the latter is given a charge voltage value as a result of the stop signal; and the signal produced by the actuated operating key (39 or 40) is cancelled by this charge voltage value; and that the capacitor is recharged or discharged by a resistor (29) having a time constant.

12. A receiver according to claim 11 characterised in that the capacitor (30) is in series in the signal line to the input (E) of the first trigger stage (32); that the resistor (29) is connected in parallel; that the connection of the capacitor (30) which is adjacent the operating keys (39, 40) can be connected to one pole of a supply voltage (logic "1") when an operating key (39 or 40) is actuated and the other connection can be connected by the electronic switch (36) to the other pole of the supply voltage (earth, logic "0").

13. A receiver according to claim 11 or 12, characterised in that the electronic switch is constituted by a switching transistor (36).

**Revendications**

1. Récepteur haute fréquence avec un dispositif de recherche automatique des émetteurs pouvant fonctionner suivant les deux sens d'accord, lancé par un signal de départ et arrêté par un signal d'arrêt dérivé du signal de sortie en S d'un démodulateur, ledit récepteur étant caractérisé en ce qu'un registre à décalage (2, 3) à deux étages au moins est prévu et commandé continûment par des impulsions d'horloge pendant la recherche; un sommet du signal de sortie en S est amplifié et converti en un signal rectangulaire (23), qui est appliqué à l'entrée (E) du registre à décalage (2, 3); un circuit combinatoire (6, 7, 9) est prévu et relié aux sorties (Q, Q̄) des étages (2, 3) du registre à décalage; et le circuit combinatoire (6, 7, 9) est commutable avec le sens de recherche, de façon à produire un signal d'arrêt (21, 22) dans les deux sens de recherche, à la sortie du circuit combinatoire (6, 7, 9) et sur le flanc du signal rectangulaire se trouvant dans la position d'accord recherchée ou à son voisinage.

2. Récepteur selon revendication 1, caractérisé en ce que le registre à décalage comporte deux étages (2, 3) et le signal d'arrêt (21 ou 22) est produit par l'état logique "10" des étages du registre à décalage (2, 3) dans un sens de recherche (19) et par l'état logique "01" dans l'autre sens de recherche (20).

3. Récepteur selon revendication 2, caractérisé en ce que le circuit combinatoire comporte deux opérateurs ET (6, 7); une entrée du premier opérateur ET (6) est reliée à la sortie non-inverseuse (Q) du premier étage (2) du registre à décalage et une autre entrée du premier opérateur ET (6) est reliée à la sortie inverseuse (Q̄) du second étage (3) du registre à décalage; une entrée du second opérateur ET (7) est reliée à la sortie inverseuse (Q̄) du premier étage (2) du registre à décalage et une autre entrée du second opérateur ET (7) à la sortie non-inverseuse (Q) du second étage (3) du registre à décalage; un signal de commande indiquant le sens de la recherche (borne 5) est appliqué à une autre entrée du premier opérateur ET (6), et, après inversion, à une autre entrée du second opérateur ET (7); les sorties des deux opérateurs ET (6, 7) sont reliées aux entrées d'un opérateur OU (9); et le signal d'arrêt (21, 22) est prélevé sur la sortie de l'opérateur OU (9).

4. Récepteur selon revendication 3, caractérisé en ce que les opérateurs ET sont constitués chacun par un opérateur NI (6, 7).

5. Récepteur selon revendication 3, caractérisé en ce que les opérateurs ET (6, 7) peuvent être bloqués par une ou plusieurs autres entrées pour supprimer le signal d'arrêt (21, 22).

6. Récepteur selon revendication 5, caractérisé en ce que les opérateurs ET (6', 7') peuvent être bloqués par un signal apparaissant pendant un temps prédéterminé après le lancement d'une recherche (retard d'arrêt, borne 44).

7. Récepteur selon revendication 5, caractérisé en ce que les opérateurs ET (6", 7") peuvent être bloqués par un signal délivré pour certains émetteurs, monophoniques par exemple (condition d'arrêt, borne 46).

8. Récepteur selon revendication 1, caractérisé en ce qu'une première bascule (32) est prévue, qui est remise à 1 pendant la recherche; et la première bascule (32) peut être remise à 0 par le signal d'arrêt.

9. Récepteur selon revendication 8, caractérisé par une seconde bascule (35), qui peut être remise à 1 dans une position ou l'autre selon le sens de recherche choisi.

10. Récepteur selon revendication 9, caractérisé en ce qu'une troisième bascule (62) est prévue, qui est remise à 1 par un premier signal d'arrêt (51); la troisième bascule (62) est interconnectée avec la première bascule (32) et la seconde (35) par des opérateurs logiques (50, 61, 48, 57, 58), de façon que la remise à 1 de la troisième bascule (62) inverse la position de la seconde bascule (35) et que la première bascule (32) ne puisse être remise à 0 par un second signal d'arrêt (52) qu'après la remise à 1 de la troisième bascule (62) par le premier signal d'arrêt (51).

11. Récepteur selon revendication 8, caractérisé en ce que la première bascule (32) peut être remise à 1 par des touches de commande (39, 40); un condensateur (30) est inséré sur le trajet du signal entre les touches de commande (39, 40) et la première bascule (32); un interrupteur électronique (transistor 36), pouvant être actionné par le signal d'arrêt, est prévu et interconnecté avec le condensateur (30) de façon que ce dernier reçoive par suite du signal d'arrêt, une tension de charge supprimant le signal produit par la touche de manoeuvre actionnée (39 ou 40); et le condensateur inverse sa charge ou se décharge sur une résistance (29), avec une constante de temps.

12. Récepteur selon revendication 11, caractérisé en ce que le condensateur (30) est en série, dans la ligne de signal, avec l'entrée (E) de la première bascule (32); la résistance (29) est branchée en parallèle; la borne du condensateur (30) située du côté des touches de commande (39, 40) est reliée à une borne d'une tension d'alimentation ("1" logique) lors de la manoeuvre d'une touche de commande (39 ou 40) et l'autre borne est reliée par l'interrupteur électronique (36) à la seconde borne de la tension d'alimentation (masse, "0" logique).

13. Récepteur selon une des revendications 11 et 12, caractérisé par la réalisation de l'interrupteur électronique sous forme d'un transistor de commutation (36).

0 004 301

Taktfrequenz f₁    Suchlauf-Richtung

Fig.1

Fig.2

U

12

t bzw. f

= log. "1"
= log. "0"

23    13

Takt    14

Q  1.Stufe
Q  2.Stufe    15

19    21    (Gatter 7)    16

Q  1.Stufe
Q  2.Stufe    17

22    (Gatter 6)
20    18

1

Fig. 3

Aufwärts
39
40
log.1
0,1μ
30
10M 29
28
Abwärts

31

4  f₁ (z.B. 10kHz)
45  f₂ (z.B. 1kHz)

35
E  Q — Abwärts — 41
T  Q̄ — 42
Suchlauf-Richtung — Aufwärts

33  34

36

32
T  Q̄
E
R  Q — 43
Suchlauf-Funktion

Stop-Bedingung  46
38
37
log.0

2  3
E
Q  Q̄  Q  Q̄
T  T

44
Stopverzögerung

6'
8
9
7'

Demodulator-Ausgang
25
11
26

24

0 004 301

2

Fig.4

Fig.5

0 004 301